Europäisches Patentamt

European Patent Office

Office européen des brevets

(11) Publication number: **0 166 699**
**B1**

(12) **EUROPEAN PATENT SPECIFICATION**

(45) Date of publication of patent specification: **05.04.89**

(21) Application number: **85830125.2**

(22) Date of filing: **27.05.85**

(51) Int. Cl.⁴: **G 01 R 19/175, H 03 K 5/153**

(54) **Circuit for detecting the passage through zero of the signal generated by an electromagnetic sensor of the phonic wheel type.**

(30) Priority: **31.05.84 IT 6756084**

(43) Date of publication of application:
**02.01.86 Bulletin 86/01**

(45) Publication of the grant of the patent:
**05.04.89 Bulletin 89/14**

(84) Designated Contracting States:
**AT BE CH DE FR GB IT LI LU NL SE**

(56) References cited:
**EP-A-0 026 588**
**EP-A-0 117 789**
**DE-A-2 640 242**
**US-A-3 768 024**

**NUCLEAR INSTRUMENTS AND METHODS,**
**vol. 163, no. 2/3, 1979, pages 535-539, North-**
**Holland Publishing Co., Amsterdam, NL; J.**
**GAL et al.: "A zero crossing discrimination**
**technique for constant fraction timing"**

(73) Proprietor: **MARELLI AUTRONICA S.p.A.**
**Piazza Sant'Ambrogio, 6**
**I-20123 Milano (IT)**

(72) Inventor: **Cotignoli, Giuseppe**
**Corso Francia 70**
**I-10093 Collegno (Torino) (IT)**
Inventor: **Fogliati, Ezio**
**Via Varaita 5**
**I-10126 Torino (IT)**

(74) Representative: **Quinterno, Giuseppe et al**
**c/o Jacobacci-Casetta & Perani S.p.A. Via Alfieri,**
**17**
**I-10121 Torino (IT)**

Courier Press, Leamington Spa, England.

EP 0 166 699 B1

## Description

The present invention relates to a circuit for detecting the passage through zero of the signal generated by a variable-reluctance electromagnetic sensor of the phonic wheel type or the like. In particular, the invention concerns a detector circuit of the type comprising a first threshold comparator with hysteresis, for connection to the sensor and for outputting a signal indicative of the passage through zero of the signal at its input.

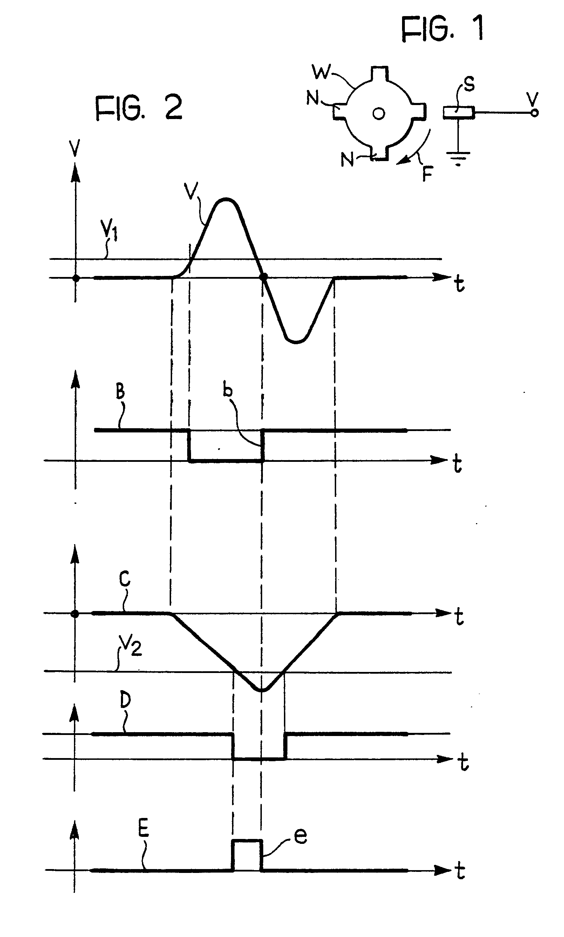

A sensor or detector of the phonic wheel type is illustrated schematically in Figure 1. It comprises, in general, a disc W rotatable about its own axis and having a series of teeth N in suitable positions. A sensor S of electromagnetic type is associated with the disc W. The disc W may have notches instead of teeth.

When the disc W is rotated, for example in the sense of the arrow F in Figure 1, each time a tooth N passes in front of the sensor S, the latter outputs a voltage signal V the trend of which as a function of time T is illustrated qualitatively in Figure 2.

The phonic wheel sensor shown in Figure 1 has various applications, particularly in the field of motor vehicles, for example, for detecting the speed of rotation of the drive shaft or for detecting the moment at which the engine pistons pass through top dead centre or bottom dead centre.

In these applications it is important to be able to determine correctly the moment of the passage through zero of the signal V output by the sensor S.

For this purpose, in the prior art, the signal V is supplied to the input of a threshold comparator circuit with hysteresis, for outputting a signal of the type shown schematically by the waveform B in Figure 2: the threshold comparator is arranged so that its output changes state (for example, passing from a high to a low level) when the signal V exceeds a threshold level $V_1$ and changes state again when the signal V falls below zero. Each rising wave front b of the signal B is thus indicative of a passage of the signal V through zero, see for example Gal & Bibok, Nuclear Instruments and Methods 163 (1979) 535—539.

The circuit for detecting the passage through zero of the signal V which has just been described has the disadvantage of being very sensitive to the effect of any disturbances picked up by the sensor S. Furthermore, if, for example, the disc W is not perfectly circular or is mounted slightly out of alignment, the signal output by the sensor may show spurious passages through zero.

In order to avoid the latter disadvantage, it has been proposed, to adopt a threshold comparator circuit with a threshold which is variable in dependence on the amplitude of the signal input to the comparator. For example see US—A—3,768,024. This solution avoids the disadvantage but is very expensive and, in any case, is sensitive to the effect of disturbing pulses of even modest power.

The object of the present invention is to provide a circuit for detecting the passage through zero of the signal generated by an electromagnetic sensor of the aforesaid type, which is reliable in operation even in the presence of disturbing pulses, and which is of fairly low cost.

This object is achieved according to the invention by a detector circuit of the type specified at the beginning, characterised in that it further includes:

an integrating circuit the input of which is connectible to the sensor,

a second threshold comparator connected to the output of the integrating circuit for outputting an enabling electrical signal only when the signal output by the integrating circuit exceeds a predetermined threshold value, and

an enabling circuit connected to the outputs of the first and second threshold comparators and arranged to output the signal generated by the first comparator only when the second comparator outputs the enabling signal.

Further characteristics and advantages of the detector circuit according to the invention will become apparent from the detailed description which follows with reference to the appended drawings, provided purely by way of non-limiting example, in which:

Figure 1 already described, shows a variable-reluctance electromagnetic sensor of the phonic wheel type.

Figure 2, already partly described, shows as a function of time the waveforms of five signals generated in operation by a detector circuit according to the invention, and

Figure 3 is a part-block circuit diagram of a detector circuit according to the invention.

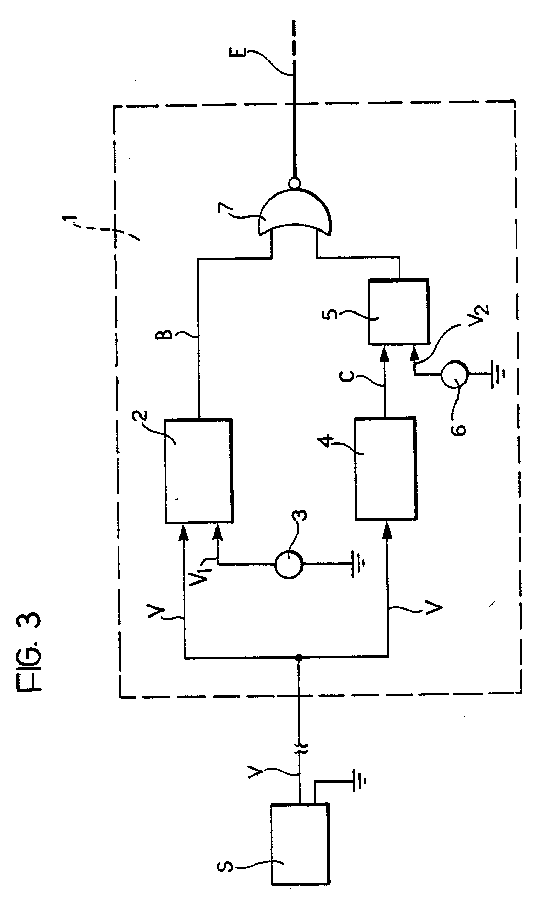

With reference to Figure 3, according to the invention an electromagnetic sensor S is connected to a circuit 1 for detecting the passage through zero of the signal V generated by the sensor. The circuit 1 includes a threshold comparator 2 (of the type with hysteresis, for example inverting) with an input connected to the output of the sensor S, and the other input connected to a source 3 of a constant reference voltage $V_1$.

The output of the sensor S is also connected to an integrating circuit 4 of active type made, for example, with the use of an operational amplifier. The output of the integrator 4 is connected to a source 6 of a second threshold comparator 5 the other input of which is connected to a source 6 of a constant reference voltage $V_2$.

The outputs of the threshold comparators 2 and 5 are connected to respective inputs of a NOR circuit 7.

The detector circuit described above operates in the following manner.

When a tooth N in the disc W passes in front of the sensor S, the latter emits a signal having the waveform V of Figure 2 as stated above. Correspondingly, the outputs of the comparator 2 and the integrator 4 output signals having the respective waveforms B and C of Figure 2. The threshold comparator 5 (for example, of a noninverting type) compares the signal C from the integrator with the voltage level $V_2$, and then outputs a signal the trend of which is substantially that of the waveform D of Figure 2. Similarly, the NOR circuit 7 outputs a signal having the waveform E of Figure 2: the descending front e of the signal E is thus indicative of the passage of the signal V through zero.

The amplitude of the signal C output by the integrating circuit 4 is proportional to the energy associated with the signal V. The threshold comparator 5 and the NOR circuit 7 therefore cause the rising front b of the signal B to be interpreted as indicative of a passage of the signal V through zero only when the corresponding signal output by the sensor S has an energy greater than a minimum value. Thus, disturbing pulses, which have amplitudes comparable to those of "true" signals but considerably less energy, are differentiated therefrom.

## Claims

1. A circuit for detecting the passage through zero of the signal (V) generated by an electromagnetic sensor (S; W) of the phonic wheel type or the like, comprising a first threshold comparator (2) with hysteresis, connected to the sensor (S) and for outputting a signal (b) indicative of the passage through zero of the signal (V) at its input, characterised in that it further includes:

an integrating circuit (4) the input of which is connected to the sensor (S),

a second threshold comparator (5) connected to the output of the integrating circuit (4) for outputting an enabling signal (D) only when the signal (C) output by the integrating circuit (4) exceeds a predetermined threshold value ($V_2$), and

an enabling circuit (7) connected to the outputs of the first and second threshold comparators (2; 5) and arranged to output the signal (b) generated by the first comparator (2) only when the second comparator (5) outputs the enabling signal (D).

2. A detector circuit according to Claim 1, characterised in that the integrating circuit (4) is of the active type.

3. A detector circuit according to Claim 1 or Claim 2, in which the first comparator circuit (2) is of the inverting type, characterised in that the second comparator circuit (5) is of the noninverting type and the enabling circuit (7) is a NOR circuit.

## Patentansprüche

1. Abtaststufe um den Nulldurchgang des Signals (V) abzutasten, das von einem elektromagnetischen Fühler (S; W) in Art eines phonischen Rads oder ähnlichem erzeugt wird, wobei die Abtaststufe einen ersten Schwellwertvergleicher (2) mit Hysterese besitzt, der mit dem Fühler (S) verbunden ist und ein Signal (b) abgibt, das den Nulldurchgang des Signals (V) anzeigt, das am Eingang anliegt, dadurch gekennzeichnet, daß die Abtaststufe weiters aufweist:

eine Integrationsstufe (4), deren Eingang mit dem Fühler (S) verbunden ist;

einen zweiten Schwellwertvergleicher (5), der mit dem Ausgang der Integrationsstufe (4) verbunden ist, um nur dann ein elektrisches Inbetriebsetzungssignal (D) abzugeben, wenn das von der Integrationsstufe (4) abgegebene Signal (C) einen vorgegebenen Schwellwert ($V_2$) überschreitet; und

eine Inbetriebsetzungsstufe (7), die mit den Ausgängen des ersten und zweiten Schwellwertvergleichers (2; 5) verbunden und so aufgebaut ist, um das vom ersten Vergleicher (2) erzeugte Signal (b) nur dann abzugeben, wenn der zweite Vergleicher (5) das Inbetriebsetzungssignal (D) abgibt.

2. Abtaststufe gemäß Anspruch 1, dadurch gekennzeichnet, daß die Integrationsstufe (4) eine aktive Integrationsstufe ist.

3. Abtaststufe gemäß Anspruch 1 oder 2, wobei der erste Vergleicher (2) ein invertierenden Vergleicher ist, dadurch gekennzeichnet, daß der zweite Vergleicher (5) ein nichtinvertierender Vergleicher und die Inbetriebsetzungsstufe (7) ein WEDER-NOCH-Glied ist.

## Revendications

1. Un circuit pour détecter le passage par zéro d'un signal (V) généré par un détecteur électromagnétique (S, W) du type à roue phonique ou de type semblable, comprenant un premier comparateur de seuil (2) avec hystérésis, relié au détecteur (S) et devant transmettre un signal (b) indiquant le passage par zéro du signal (V) à son entrée, caractérisé par le fait qu'il comprend de plus:

un circuit intégrateur (4) dont l'entrée est reliée au détecteur (S);

un second comparateur de seuil (5) relié à la sortie du circuit intégrateur (4) pour transmettre un signal électrique d'autorisation (D) uniquement lorsque le signal (C) transmis par le circuit intégrateur (4) excède une valeur de seuil prédéterminée ($V_2$); et

un circuit d'autorisation (7) relié aux sorties des premier et second comparateurs de seuil (2, 5) et conçu de manière à produire le signal (B) généré par le premier comparateur (2) uniquement lorsque le second comparateur (5) transmet le signal d'autorisation (D).

2. Un circuit détecteur selon la revendication 1, caractérisé par le fait que le circuit intégrateur (4) est du type actif.

3. Un circuit détecteur selon la revendication 1 ou 2, dans lequel le premier comparateur (2) est du type inverseur, caractérisé par le fait que le second circuit comparateur (5) est du type non-inverseur, et par le fait que le circuit d'autorisation (7) est un circuit non-ou.

FIG. 1

FIG. 2

FIG. 3